# EUROPEAN PATENT APPLICATION

(11) **EP 4 496 332 A1**
(43) Date of publication of application: **22.01.2025**
(21) Application number: 24186058.4
(22) Date of filing: 02.07.2024
(51) Int. Cl.: H04N 23/73, G01C 11/02, H04N 23/75, H04N 25/532, H01L 27/146, H04N 25/62, H04N 23/71, H04N 23/81, G03B 9/08, H04N 25/531

(54) **AERIAL CAMERA WITH ELECTRONIC GLOBAL SHUTTER AND EXTERNAL DISPERSIVE ELEMENT**

(30) Priority: 21.07.2023 EP 23186936
(71) Applicant: Hexagon Technology Center GmbH, 9435 Heerbrugg (CH)
(72) Inventor: GRAF, Roland, 9033 Untereggen (CH); STIGWALL, Johan, 9000 St. Gallen (CH)
(74) Representative: Kaminski Harmann

(57) **Abstract**

The invention relates to an aerial camera instrument configured to acquire high-resolution aerial images from a target area. The aerial camera instrument comprises (i) an imaging sensor having an electronic global shutter functionality, (ii) an external dispersive component, and (iii) a coupling functionality configured to synchronize the electronic global shutter functionality and the external dispersive component.

## Description

### FIELD OF THE INVENTION

The present invention relates to a structure and operation of an aerial camera instrument configured to acquire high-resolution aerial images from a target area. The aerial camera instrument comprises an imaging sensor with an electronic global shutter and an external shutter component.

### BACKGROUND OF THE INVENTION

Aerial cameras are used to survey swathes of land by capturing photos of the earth surface directly below and/or at oblique angle to the aircraft. Some key challenges of high-resolution aerial photography are small ground sampling distance, high flying speeds, and the requirement to also survey at varying ambient light conditions.

Due to the high flight speed, many methods or technical solutions common in standard photography are undesirable or even simply not applicable for aerial photography. E.g. the typically applied rolling shutter method, wherein a frame is captured not by taking a snapshot of the entire scene at a single instant in time, but rather by scanning across the scene rapidly, would lead to "rolling shutter effects", i.e. perspective shifts during exposure. Said rolling shutter effect would cause complication for software algorithms, which assume that each image was taken at the same time instant. The preferred solution for aerial photography is thus a global shutter.

For mechanical shuttering central leaf shutters are commonly used, optionally in combination with adjustable apertures. With large apertures, the shutter speed is a limiting factor, e.g. a mechanical leaf shutter would not be fast enough to avoid overexposure in strong sunlight.

The aperture is rarely adjusted during a single flight, so it experiences little wear. The shutter on the other hand needs to actuate forth and back for every image. With frame rates of up to e.g. 5 fps, hour-long flights and multi-camera systems, this can add up to hundreds of thousands of actuations per flight. Wear of the shutters thus cannot be neglected, typically leading to designs with replaceable shutter mechanism - adding both size and cost. When a shutter fails during flight, the flight must be cancelled, the shutter exchanged and a new flight planned. Reducing the number of shutter actuations or getting rid of the mechanical shutter completely would thus be desirable.

The availability of very performant / sensitive imaging sensors - e.g. backside illuminated CMOS imaging sensors - with an electronic global shutter allows to design and build compact camera systems, which can work with short integration times. Having no moving parts, the switching speed is orders of magnitude faster than for mechanical shutters, e.g. 1 µs for electronic shutters as compared to 1 ms for mechanical shutters. It is thus possible to avoid overexposure even in the brightest conditions and with large apertures. Contemporary imaging sensors are typically not sensitive to light that came before integration start since it can perform a pixel reset before that. These properties are also advantageous as the sensitivity to movement resulting in blur is decreasing with shorter, more defined illumination times. Electronic global shutters also avoid rolling shutter effects while providing shutter speeds not practically achievable by mechanical global shutters. Additionally, the electronic shuttering is extremely precise and repeatable, making it possible to expose all cameras in a multi-camera setup exactly synchronous - which may simplify or speed up aerial triangulation processing since intra-camera exposure delay variation can be neglected.

Due to the sequential readout of contemporary pixel-based imaging sensors the readout phase is typically orders of magnitude longer than the integration phase. Unlike to mechanical shutters, electronic shutters do not truly block the light from reaching the sensor, but blocking charge movement to a storage node that is protected from incoming light, but still in very close vicinity to the sensitive area. Due to unwanted effects such as reflections and scattering, some photons may unfortunately end up in the storage node. In other words, the image sensor is to some degree still photosensitive via direct or indirect light not only during the integration phase, but also at other times, including the readout phase. Such parasitic light signal (PLS) causes imaging artifacts that degrade image quality, in particular when the photographed scene comprises a high reflectivity surface, such as water, polished metal or glass surfaces, solar panels, reflecting direct sunlight to the camera. The PLS also depends on the wavelength of the light and type of sensor exposed to the light. The effect is most pronounced in the near-infrared regime, in particular 750-950 nm.

Typically due to the relative movement of the camera to the target area PLS causes a long degraded, in particular oversaturated, area on the image data, which is known as a PLS streak. There are some post-processing solutions to eliminate the PLS artifacts, e.g. by interpolation. However, it is desirable to limit the spatial extent, i.e. the length of the PLS streak, or its intensity, i.e. to attenuate it from complete oversaturation to a brightness and color error.

Alternatively or additionally, mechanical image stabilization as a function of the current flight speed and the ground sampling distance can also be used by a so-called forward motion compensation (FMC) mount, e.g. as disclosed in EP 4 008 995 A2. The FMC mount mechanically moves the camera or part thereof during the integration phase essentially parallel to the flight direction in order to provide image data without forward motion blur. Typically, these kind of camera systems are operated with a further gyro stabilized mount, to compensate for aircraft drift angles, and blur caused by aircraft vibrations and angular motion. Alternatively, a two- or three-axis motion compensation (MC) mounts compensating for airplane angular motion might be utilized. Said MC mounts operate analogously to the FMC mounts. From here on, unless otherwise provided, MC mount is used as a generic term covering both the single- and multiaxis compensation mounts. Such systems can also be used to mitigate PLS effects. A downside of available mechanical solutions is a large construction resulting in a large camera body. Moreover longer stabilization times, e.g. an extension to the readout phase, require longer strokes of the MC mount, which leads to even more complex mechanisms. Therefore, it is desirable to reduce the required stabilization times.

### OBJECT OF THE INVENTION

In view of the above circumstances, one object of the present invention is to enable improved compact aerial camera instruments providing high image quality.

A further object of the present invention is to improve the wear properties and the useful lifetime of components of aerial camera instruments.

A further object of the present invention is to lessen the complexity and/or the performance requirements of mechanical components of an aerial camera instrument while maintaining or improving the image quality.

A further object of the present invention is to provide an aerial camera instrument wherein the impact of the parasitic light is at least reduced, preferably eliminated.

These objectives are at least partly achieved by realizing the characterizing features of the independent claims. Features, which further develop the invention in an alternative or advantageous manner are described in the dependent patent claims.

### SUMMARY OF THE INVENTION

The present invention relates to aerial camera instrument configured to acquire high-resolution aerial images from a target area. Camera instrument in the sense of the present invention expresses that the instrument might comprise further components, in particular a support configured to mount the camera instrument to an airborne vehicle. Unless otherwise specified, a camera is to be understood as a standalone component may or may not be mounted on the airborne vehicle.

By way of example target area is a terrestrial target area, in particular a terrestrial target area at least 100 meter from the camera. The airborne vehicle might be a fixed wing aircraft, a helicopter or a heavy unmanned aerial vehicle. The airborne vehicle, thus the camera instrument itself, might travel with velocities in excess of 50 ms⁻¹ or 100 knots relative to the target area during the acquisition of the aerial photographs. Camera instruments in the sense of the present invention are configured to acquire high-resolution aerial photographs with similar specifications in mind.

The inventive camera instrument is especially suited for aerial mapping and surveying. Such aerial mapping and surveying systems are foreseen to comprise one or more of the inventive camera instruments and a scanning LIDAR. The LIDAR is designed to scan an extended area, and it is required that the camera system comprising one or more of the inventive cameras also covers this area so that the point cloud from the LIDAR can be colored using image data. To e.g. make it easier to discriminate vegetation from manmade objects, one or more cameras might acquire aerial photographs in the near infrared spectrum.

The aerial camera instrument comprises an imaging sensor. The imaging sensor comprises an electronic global shutter functionality providing for each pixel a simultaneous start and stop for an integration phase. The integration phase corresponds to capturing light and converting it into pixel-resolved electronic signals. In other words, for the inventive camera instrument the integration phase is activated solely by the electronic global shutter functionality. The integration phase, depending on the ambient light, can be less than 1 ms long, in particular down to 300 µs long. In other words, shutter speeds up to 1/1000 s, preferably up to 1/3000 s, are required.

The imaging sensor further exhibits a readout phase. The readout phase corresponds to transforming the pixel-resolved electronic signals into digital image data. The readout of the pixels is typically performed sequentially. As a result, the readout phase requires a longer period than the integration phase, particularly its length is in excess of 10 ms. While in principle possible, the cases with simultaneous activation of the integration and readout phases will not be discussed in detail. The specific properties of such cases can be applied accordingly.

The skilled person knows a plurality of sequential readout methods. A non-exclusive list comprises (i) row-by-row readout, wherein the rows of pixel are read out sequentially, (ii) interleaved readout, wherein e.g. first a set of even rows are read out which is followed by reading out of a set of odd rows, (iii) random readout, etc. The skilled person understands that while some readout methods would provide synergetic effect with the claimed invention in the reduction of the PLS effect, the claimed invention is not limited to any specific readout technique.

The aerial camera instrument comprises an external shutter component. The external shutter component is configured to provide an open state and a closed state. The open state provides light transmission towards the imaging sensor. The closed state provides reduced, in particular at least locally reduced, light transmission towards the imaging sensor as compared to the open state. Open and closed state in the sense of the invention is to be interpreted via the resulting image data. Particularly the imaging sensor comprises the global electronic shutter, i.e. closed state in the sense of the invention is a state which improves the functionality of the global electronic shutter. Or in other words the amount of light reaching at least the most exposed and/or oversaturated pixels is reduced. This can be achieved by blocking or deflecting the light, but also by dispersing/defocusing/blurring the light thus the same light intensity is divided by multiple pixels. In yet another words, closed state represents reduced imaging contrast with respect to the open state. External in the sense of the present invention means that said shutter component does not play a role in setting the integration phase. In other words, the aerial camera instrument, notwithstanding certain artifacts, can acquire high-resolution aerial images from the target area without operating the external shutter component. The external shutter component can be realized both as a dismountable additional component or as integral part of the aerial camera instrument.

Preferably the external shutter component is realized as a dispersive component. Dispersive components in the sense of the invention are configured to manipulate the light and might be based on diffraction or refraction. A non-exclusive list of such dispersive components includes diffraction gratings, particularly switchable gratings, liquid lenses, liquid crystal shutters, polymer-dispersed liquid crystals, or 4^{th} generation optics components such as liquid crystal cells. From here on, unless explicitly provided otherwise e.g. by referring to mechanical shutter components, external shutter and external dispersive component are used as equivalents.

The aerial camera instrument comprises a coupling functionality. The coupling functionality is configured to provide a settable coupling of the electronic shutter functionality and the external shutter component. Said settable coupling provides for different activation settings of the electronic shutter functionality and the external shutter component relative to each other. The coupling functionality can be implemented, among other options, by a hardware component, as a part of a computer program product controlling further aspects of the aerial camera instrument or as a dedicated computer program product targeting this aspect, as well as a combination of such embodiments.

In some embodiments, the coupling functionality is configured to provide different coupling settings, i.e. different coupling modes, as a function of different ambient light conditions and/or different reflection conditions associated with the target area. In particular the coupling functionality might provide that for conditions, wherein the PLS effects are negligible, i.e. overcast weather, the external shutter is not activated. Ambient light conditions might be provided by a measurement. Ambient light and/or reflection conditions might be provided manually by an operator input. Alternatively, the operator might provide or select certain input data, e.g. clear sky, time of image acquisition 3 p.m., and the coupling functionality provides an appropriate mode. Alternatively, the coupling functionality can automatically access the required input data.

In some embodiments, the aerial camera instrument is configured to access navigation data. Navigation data in the sense of the invention corresponds to a planned route comprising a plurality of target areas. The aerial camera instrument is configured to derive the different reflection conditions based on the navigation data. Navigation data might particularly provide water surfaces, solar farms, urban areas and similar high reflectivity targets. In some specific embodiments, the coupling functionality is configured to provide for automatic setting of the different activation settings as a function of the navigation data. Alternatively or additionally, the coupling functionality might provide a warning signal to the operator regarding a presence of high reflectivity objects in the target area.

In some embodiments, the aerial camera instrument, in particular the imaging sensor, provides for measuring an ambient light intensity. For an array comprising a plurality of cameras, a further camera might provide the ambient light intensity data and/or the inventive camera instrument might provide ambient light intensity data for the further cameras. Alternatively or additionally, the aerial camera instrument provides for determining an expected intensity within an image of the imaging sensor, in particular based on precedent digital image data. The coupling functionality is configured to provide for automatic setting of the different activation settings as a function of the measured ambient light intensity and/or the expected intensity within the image of the imaging sensor.

In some embodiments, the coupling functionality is configured to provide for automatic setting of the different activation settings as a function of meteorological information, in particular solar irradiation information and/or cloud coverage information.

In some embodiments, the different activation settings comprise a setting wherein only the electronic shutter functionality is activated, and a setting wherein both the electronic shutter functionality and the external shutter component are activated. Activating the external shutter component only on occasions when it is expected to provide benefits for the image quality reduces the number of activations, i.e. the wear of the external shutter component. In other words, the useful lifetime of the external shutter component can increase.

In some specific embodiments, the different activation settings comprise a setting wherein (i) the open state of the external shutter component is set for the integration phase, and (ii) the closed state of the external shutter component is set for at least a part of the readout phase, in particular for the majority of the readout phase. In other words, the external shutter protects the imaging sensor from artifacts, in particular PLS-related artifacts during the readout phase. One advantage of this setting that the extent of the PLS-affected part is smaller, which enables a more accurate correction, e.g. based on interpolation. A randomized and/or structured readout of the pixel-resolved electronic signal is beneficially combinable with such embodiments. As a further advantage, shorter PLS streaks also makes it more feasible to hold the image still with the MC.

In some embodiments, the different activation settings comprise settings providing different invocation of the closed state of the external shutter component relative to a time interval provided by the readout phase of the imaging sensor. In particular, the closure of the external shutter component could be timed such that the highest proportion of the readout phase might be performed in the closed state of the external shutter component. Since the integration phase has a negligible length as compared to the shuttering of the external shutter component a pixel reset of the imaging sensor and the integration phase might be performed when a command to close the external shutter component is already provided.

In some embodiments the aerial camera instrument further comprises a (forward) motion compensation - (F)MC - unit. Such MC units are typically utilized to reduce the motion blur. The MC is configured (i) to derive motion data corresponding to a relative motion of the camera instrument to the target area projected onto a stabilization plane, and (ii) to provide start and stop signal for a compensation movement of the camera instrument based on the derived motion data. The coupling functionality is configured to provide a settable activation settings for the MC unit regarding a coupling with any one of the electronic shutter functionality and the external shutter component.

In some specific embodiments, the coupling functionality is configured to provide a stop signal for a compensation movement of the camera instrument (i) in a first MC coupling mode, in response to shutter closed notification, indicating a closed state of the external shutter component, (ii) in a second MC coupling mode, in response to a readout start notification, indicating a readout phase of the imaging sensor, and (iii) in a third MC coupling mode, in response to a readout stop notification, indicating the completion of the readout. The first and second MC coupling modes correspond to the settings regarding the activation of the external shutter component.

In the first MC mode, providing the compensation movement until the external shutter component is closed and no artifacts are expected improves the image quality. The advantage of such embodiments is that the MC stroke has to be extended to cover only the shuttering period of the external shutter component and not the whole readout phase. Such embodiments of the invention are beneficially applicable to the refurbishment of existing systems, since instead of exchanging the complete MC mechanisms installing an eventually simple and comparatively inexpensive external shutter component could provide similar performance increment.

The second MC coupling mode refers to the prior art praxis, wherein the compensation movement is halted when the integration phase stopped. This mode can be advantageously utilized when ambient light conditions and/or reflection conditions associated with the target area do not necessitate the utilization of extended compensation movement and/or the usage of the external shutter component.

The third MC coupling mode corresponds to a case, wherein the motion compensation is active for the whole acquisition of the image. The disadvantage of this mode is the need for longer MC strokes. Advantageously, however, PLS effects are typically present with high level of ambient light. Therefore, almost no MC motion is needed for the integration time, so all stroke is available for PLS-compensation. While for low ambient light conditions a long stroke is needed during integration phase, but none during readout.

By way of example, the MC unit was described by terms of a single-axis FMC unit. The present invention is not limited to such system and equally applicable to multi-axis MC units having a second stabilization plane and/or configured to provide rotation compensation. Moreover, especially for multi-axis MC units, alternative compensation movements might also be performed during the shuttering of the external shutter component. In particular, the MC unit might provide a movement orthogonal to the motion direction so that the PLS streak becomes wider and thus less bright. Alternatively, the MC might provide a compensation motion is steps so that a continuous PLS streak become a string of bright spots covering a much smaller image area.

In some embodiments, the imaging sensor is embodied as a back-illuminated CMOS imaging sensor comprising at least 4000×4000 pixels, and is configured to provide a refresh rate of at least 1 image/sec. In some specific embodiments, the imaging sensor is embodied as an RGB sensor and/or, a panchromatic sensor, and/or a sensor configured to provide near-infrared images. The photosensitive area of the imaging sensor is smaller than an area of a full-frame imaging sensor, in particular a diagonal of the sensitive area is 19.3 mm.

In some embodiments, the external shutter component is embodied as a mechanical shutter, in particular a central leaf shutter. The mechanical shutter is configured to fully block light transmission towards the imaging sensor in the closed state.

In some specific embodiment, the mechanical shutter is configured to provide a mechanical shutter speed of at least 1/50 s. In other words, the shuttering of the mechanical shutter is irrelevant to the integration times. The shuttering of the mechanical shutter is configured ensure that the least amount of further pixels are oversaturated.

In some embodiments the electronic global shutter is configured to provide electronic shutter speed of at least 1/2000 s and a shutter efficiency in excess of 1000, wherein the shutter efficiency corresponds to a difference in sensitivity during the integration and readout phases.

In some embodiments, the external shutter component is embodied as a liquid crystal (LC) shutter. The LC shutter is configured to provide a contrast in excess of 100. The electronic global shutter is configured to provide electronic shutter speed of at least 1/2000 s. The electronic shutter is configured to provide a shutter efficiency in excess of 1000. While LC shutters on their own cannot suppress artifacts like PLS, according to the present invention they are not used as standalone components, rather as an auxiliary component to improve the shutter efficiency of the electronic shutter functionality. LC shutters are advantageous as they do not exhibit mechanical components, thus their shutter speed is not limited to mechanical movements and experience no mechanical wear. In particular, shutter speeds up to 1/5000 s are achievable with contemporary designs.

In some embodiments, the external shutter is embodied as a dispersive element with variable scattering states. In particular the dispersive element (i) comprises an element with a polymer-dispersed liquid crystal (PDLC), and/or (ii) is configured to provide a shutter speed of at least 1/50 s. In PDLCs a liquid crystal is dispersed as small droplets inside a solid polymer substrate. When no voltage is applied, the crystals align randomly in each droplet. Since the liquid is strongly birefringent, this variation in orientation causes a variation in refractive index. The variation in refractive index in turn diffuses the light since it is refracted in different direction at each polymer-LC interface. When applying a voltage, all LC molecules in all droplets align to the electric field, thus removing the variation in refractive index and making the device clear. A drawback of contemporary PDLC is the slow clear to diffuse switching as it is based on passive relaxation. Typical switching times are in the range of few tens to few hundreds of milliseconds.

In some embodiments, aerial camera instrument comprises a support element configured to provide a releasable fitting between the external shutter component and a housing of the camera instrument. These embodiments are advantageous as they allow a retrofit of an external shutter component to an existing aerial camera system. Moreover, such systems allow an easy replacement of a worn-out shutter. The support element might be realized by (i) a bayonet mount, (ii) a groove or rail mount, (iii) a threaded mount, and (iv) a quick release unit. The skilled person understands that the above list is non exhaustive and may include any further suitable alternative.

Alternatively, the external shutter component, in particular when it is realized as a dispersive component might be placed between the imaging optics and the imaging sensor. Unlike to a mechanical shutter such dispersive elements typically contain no moving parts, thus ease of replacement is not particularly important. By placing the dispersive element close to the image sensor a reduction of the size and with that the costs and the environmental impact can be reduced.

In some embodiments, the external shutter component is embodied as a dispersive component.

In some embodiments, the dispersive element comprises a switchable diffuser. In some specific embodiments, the diffuser comprises (a) a first transparent solid component, in particular a first glass plate, (b) a second transparent solid component, in particular a second glass plate, (c) a liquid component arranged between the first and second transparent solid components, particularly a liquid crystal, and (d) an electric actuation element electrically coupled to the liquid component and configured to provide the open state and the closed state by respectively applying a first electric signal and a second electric signal to the liquid component, in particular wherein the first and second electric signals are provided by a square-wave signal. In some specific embodiments the peak-to-peak voltage is in excess of 50 V, particularly in excess of 100 V.

The switching from closed to open state and vice versa might be in the millisecond range particularly 1-3 ms or better. The liquid component is preferably realized as thin liquid film, particularly having 1-15 µm thickness, particularly 2-10 µm, more particularly about 5 µm. Such low thickness is advantageous as it allows a high transmission rate above 90% in the open state. Moreover the low thickness also allows lower voltages because the field strength is the voltage divided by the thickness.

Such components are based on switching the homogeneity in refractive index of a liquid crystal material. In the clear or open state, the material is homogenous and thus does not scatter. In the diffuse or closed state, the refractive index varies randomly so that the material becomes opaque. Liquid crystals are well suited for this since they provide a strong birefringence, i.e. difference in refractive index depending on orientation. By orienting all molecules in the same direction, the material becomes clear, by randomizing the orientation it becomes opaque. The difference lies in how the orientation is modulated.

In some embodiments, the external dispersive component comprises a liquid lens. Liquid lenses contain a transparent liquid shaped into the shape of a lens by a thin, flexible transparent membrane. By pumping more or less liquid into the lens cavity, the power of the lens can be varied. Typically, the pump is realized using a voice-coil actuator which pushes onto another part of the membrane, and 1 ms switching speed can be achieved. To compensate for temperature-induced effects, the lens often has a temperature sensor built in and a controller which regulates the voice-coil current.

In some embodiments, the external dispersive component comprises a diffraction grating. Particularly the diffraction grating might be embodied as a switchable grating comprising structured alignment layers formed of liquid crystal. The inventive camera instruments collect light over a simultaneously large surface and angular spectrum, thus the switchable grating might need to provide a very large steering angle to move the steered image enough so that it separates completely from the primary image. It also needs good diffraction efficiency (low zeroth-order) over a large bandwidth. For suppressing the PLS and similar broadband artifacts, however, the wavelength dependence of the steering angle is advantageous as the intensity of the higher order portions is reduced

### BRIEF DESCRIPTION OF THE DRAWINGS

By way of example only, specific embodiments of the invention will be described more fully hereinafter with reference to the accompanying figures, wherein:
Figure 1 depicts an aircraft performing aerial photography over an area comprising objects with different reflectivity.
Figure 2a depicts the schematics of CMOS-imaging sensor.
Figure 2b depicts the schematics of an appearance of parasitic light signal in a CMOS imaging sensor.
Figure 3a depicts the schematic effect of a mechanical global shutter.
Figure 3b depicts the schematic effect of an LC-based external shutter.
Figure 3c depicts the schematic effect of an element with a polymer-dispersed liquid crystal.
Figures 3d and 3e depicts the schematics of a switchable diffuser based on fourth-generation optics.
Figure 4 schematically depicts some embodiments of the coupling functionality.
Figure 5 schematically depicts an embodiment of the coupling functionality providing a first MC coupling mode.
Figure 6 schematically depicts the input and output data relating to the coupling functionality.
Figure 7 schematically depicts an open state and some options to reduce the light intensity by various dispersive elements.

### SPECIFIC EMBODIMENTS OF THE INVENTION

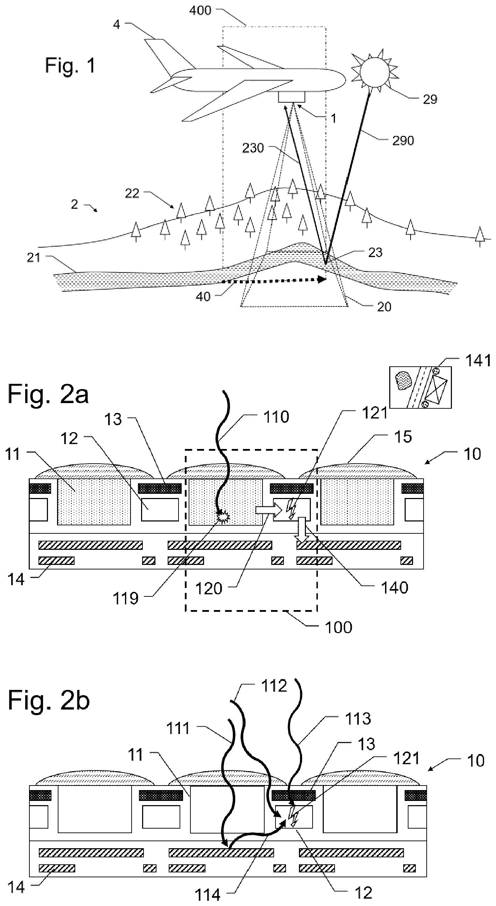

Figure 1 shows an aerial camera instrument **1** carried by an aircraft **4** to acquire high-resolution aerial images from a target area **2** while the aircraft **4** moves along a flight direction **40** relative to the target area **2.** The camera instrument **1** is usually mounted together with further surveying elements and cameras aligned in a known way relative to the usual flight direction **40.** The depicted camera face towards Nadir ("straight down"). Alternative mountings, e.g. the camera could point obliquely to a side or forwards or backwards with respect to the flight direction **40** are also within the sense of the present invention. The relative movement of the field of view **20,** in particular a projection of said movement into a stabilization plane **400** corresponding to the flight direction **40,** might be compensated by an elaborate mounting.

The depicted target area **2** comprises areas with different reflectivity e.g. the forest **22** or the river **21.** The latter is considered as a partly mirror-like surface. In other words, a non-negligible part of the light **290** from the Sun **29** is reflected specularly. Since the Sun disc appears ~50.000 times brighter than a diffusely reflecting white surface specularly reflected **23** light **230** can be orders of magnitude brighter than the light from other sources. Contemporary mechanical shutters are not fast enough to avoid overexposure with large aperture lens, therefore electronic shutters are utilized. The disadvantage of electronic shutters is that they cannot completely prevent light from entering the sensor, in particular from causing an electronic response. This hinders a complete blocking of said reflected light **230** by contemporary electronic shutters.

Figure 2a depicts a generic back illuminated CMOS imaging sensor **10** with a plurality of pixels **100.** While many features of the invention will be illustrated in combination with back-illuminated CMOS imaging sensors **10,** the present invention is not limited to this specific type of imaging sensor **10.** The specific features of different types of imaging sensors **10** might be applied accordingly.

The pixels **100** of the depicted imaging sensor **10** respectively comprise a light sensitive domain **11,** i.e. comprising active cells like photodiodes, a storage domain **12,** a blocking shield **13,** the respective electronic wiring **14** and optionally a microlens **15.** Said microlens **15** improves the light collection efficiency.

The light sensitive domain **11** converts the captured light **110** into electric charge **119.** The electric charge **119** is then accumulated **120** in the storage domain **12,** e.g. via a drift mechanism and thereby providing pixel-resolved electric signal **121.** In the readout phase, the pixel-resolved electric signal **121** is accessed **140** via the electronic wiring **14** to provide electronic image data **141.**

While Figure 2a depicts the normal mode of operation of the CMOS sensor **10** during an integration phase Figure 2b depicts the generation of electric signal **121** caused by parasitic light **111-114** in an insensitive state of the sensor **10.** In the insensitive state, the charge generation in the light sensitive domain **11** and/or a charge transfer from the light sensitive domain to the storage domain **12** is minimal. However, electric signal **121** might be generated or modified because of parasitic light **111-114** directly reaching the storage domain **12.** The light might pass through **113** the imperfect blocking shield **13,** might reach the storage domain directly in an oblique angle of incidence **112** or the incident light **111** might be reflected/scattered **114** towards the storage domain **12** by the metal wiring **14.** Since a readout, corresponding to said insensitive state, lasts typically orders of magnitude longer than the actual integration, a bright incident light **111-113** might cause a considerable electric signal **121.**

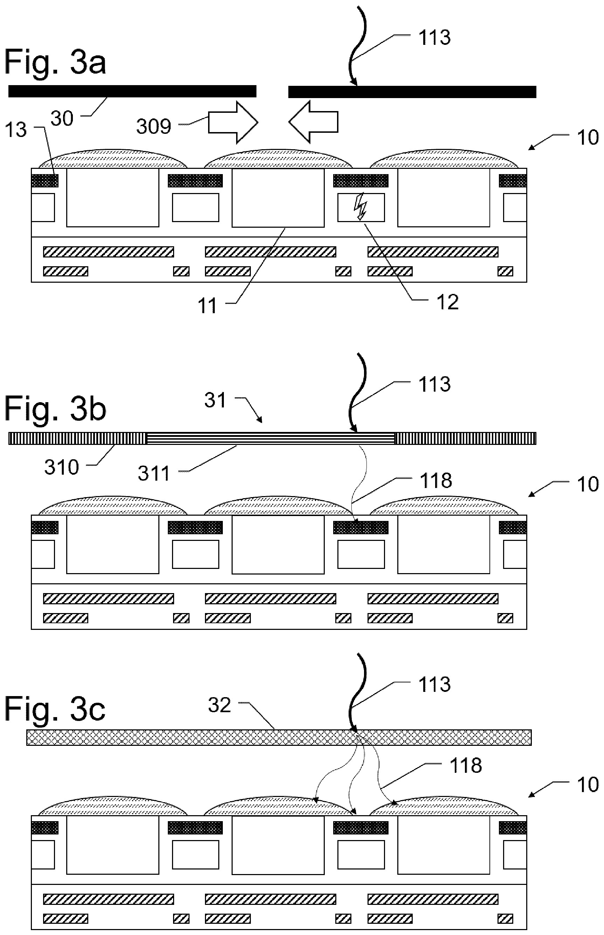

Figure 3a depicts the effect of a mechanical shutter **30,** in particular a central leaf shutter, transitioning **309** to the closed state. The shutter **30** and the sensor **10** are off-scale for transparency reasons. Since the mechanical shutter **30** is an external shutter component it can provide full coverage and can be made sufficiently thick to completely block the incident light **113,** unlike to the blocking shield **13.** In other words, in the closed state of the mechanical shutter **30** no light is transmitted towards the imaging sensor **10.** It is important to note, however, that the integration phase is provided alone by the imaging sensor **10,** i.e. the global electronic shutter preventing a charge transfer between the light sensitive domain **11** and the storage domain **12.** The mechanical shutter **30** merely serves to block the parasitic light. Owing to that, the shutter speed requirements for the mechanical shutter **30** are relaxed. Therefore, a slower, i.e. an inexpensive and/or robust, mechanical shutter **30** is able to perform the required function.

Figure 3b depicts an LC shutter **31** during transitioning, wherein a part is transformed to a closed state **311** and another part is still in the open state **310.** Since said transition is fast this does not represent a typical situation. The skilled person understands that the electronic global shutter provides the main shutter effect for the inventive camera instrument. The purpose of the LC shutter **31** is to sufficiently dampen the incoming light **113,** such that the light transmitted **118** in the closed state towards the imaging sensor **10** would not provide significant artifacts, in particular PLS-related artifacts. Owing to that, both the shutter speed as well as the contrast requirements of the LC shutter **31** are relaxed. I.e. and slower and less performant, i.e. inexpensive and/or more transparent LC shutters **31,** which cannot be applied as stand-alone shutters, could perform the required function.

Figure 3c depicts an external shutter component comprising an element with a polymer-dispersed liquid crystal **32** in the closed state. Such design works similarly to the LC shutter of Figure 3b, with an additional effect that incoming light **113** is dispersed, i.e. the transmitted light **118** is affecting a plurality of pixels of the imaging sensor **10,** each with reduced intensity. In other words, the contrast of the resulting digital image is reduced. While high contrast is generally beneficial a reduction of the contrast reduces the intensity of the PLS artifact, ideally to a level comparable to a background noise. Even for cases when the PLS affects the resulting image, avoiding oversaturation is advantageous for a correction by post processing.

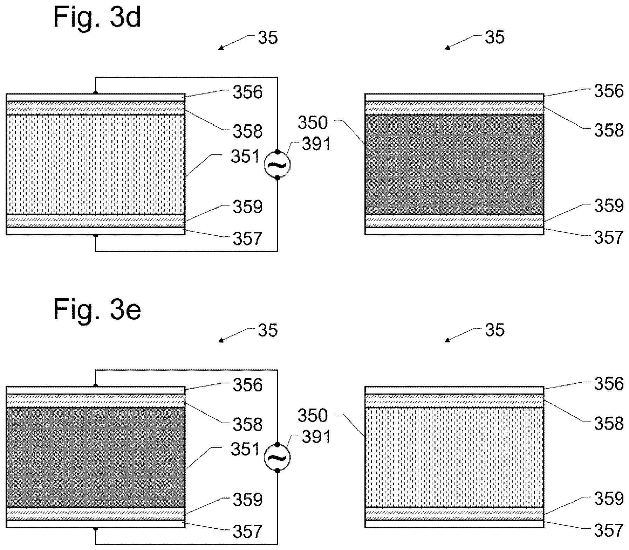

Figure 3d depicts an example of a switchable diffuser **35.** The depicted diffuser **35** comprises a first glass plate as first transparent solid component **358** and second glass plate as a second transparent solid component **359.** Respective transparent electrodes **356,357** are arranged on outer side of the transparent solid components **358,359.** The electrodes **356,357** might comprise indium-tin-oxide, graphene or suitable alternative conductive materials. Alternatively, the respective transparent solids **358,359** might be made of such conductive materials or comprise conductive regions.

The electrodes **356,357** are connected to the respective poles of an electric actuation element **391,** depicted as an AC signal generator. The electric actuation element **391** is configured to provide a first electric signal and a second electric signal to the electrodes **356,357.** Electric signals in the sense of the invention might be specific electrostatic states provided by the electrodes **356,357.** A first electric signal might be an electrified state producing a electric field between the electrodes **356,357** and the second electric signal might an absence of said electric field. A first electric signal might correspond to a first polarity of the electric field between the electrodes **356,357** and the second electric signal might correspond to a second polarity, which is a reverse polarity of the first polarity. Alternatively, the electric signals in the sense of the invention might relate to a dynamic state of the electric field. Particularly, the first electric signal might be a higher frequency electric waveform than the second electric signal. Alternatively or additionally, the first electric signal have higher amplitude as compared to the second electric signal. The skilled person understands that all of the listed options might also be realized in a mirrored manner, i.e. exchanging the roles of the first and second electric signals.

The depicted diffuser **35** also comprises a liquid component arranged between the first **358** and second solid components **359.** The left-hand panel depicts an open state **350** of the liquid component when the electric actuation element **391** provides an electric field. The right-hand side depicts the closed state **351** of the in the absence of the field. The liquid is transparent to the light in the open state **350** but it is opaque in the closed state **351.** Opaque in the sense of the invention might also comprise hazed translucent, or "milky" states.

For applications when a quick transition towards the closed state **351** is required electrically activated closed states **351** are preferable as shown in Figure 3e. Reverse mode polymer dispersed liquid crystals or dynamic scattering based diffuser are known to provide such effects. The present invention is however not limited to the mentioned embodiments.

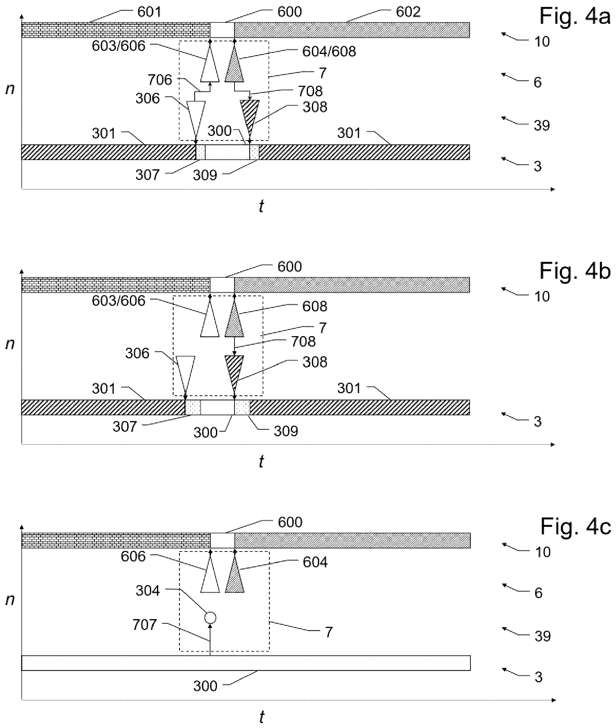

Figure 4a shows a first embodiment of the coupling functionality **7** using a schedule depicting the state **600-602** of the imaging sensor **10,** the commands **603,604,606,608** provided by the electronic global shutter **6,** the state **300,301,307,309** of the external shutter component **3,** the command **306,308** provided by its controller **39** as well as the activation commands **706,708** provided by the coupling functionality **7** in the categories axis (n). In Figures 4-5 bars represent a certain phase or state, with transition phases marked with dotted pattern, triangles represent commands to transit to a certain phase or state, while circles represent a notification indication an existence or a reach of a state. For the sake of clarity, only the command sequence for a single camera is shown. In a multi-camera system, there is also a need to synchronize multiple cameras. The individual camera will thus receive a trigger from an outside source, which starts the sequence. The claimed invention is applicable to both cases.

In the depicted embodiment the starting state is so, that the imaging sensor **10** is in a dark phase **601,** i.e. neither is light integrated nor is the pixel resolved electronic signal read-out. The external shutter component **3,** in particular a mechanical shutter, is in a closed state **301.** To take into account the variable latency of the mechanical shutter first an external shutter opening command **306** is generated, which causes the external shutter component **3** to transit **307** from the closed state **301** to the open state **300.** The coupling functionality **7** provides **706** an integration start **606** command for the electronic global shutter **6** with a delay corresponding to a transition phase **307** of the external shutter component **3.** In response to the integration start command the imaging sensor **10** changes to the integration phase **600.** The electronic global shutter **6** and the imaging sensor **10** can provide the integration phase **600** without any significant transition. A pixel reset **603** is also provided for the imaging sensor **10,** which causes a discarding of any pixel resolved signal corresponding to a previous phase, in particular the dark phase **601.** The electronic global shutter **6** then provides an integration stop **608** command, for which the imaging sensor **10** terminates the integration phase **600.** In parallel, a readout start **604** command is also provided, which sets the imaging sensor **10** into the readout phase **602.** The coupling functionality **7,** in response, also provides **708** an external shutter closing command **308.** Said command is provided **708** with a delay, which is not strictly necessary. In response, the external shutter component **3** transits **309** from the open state **300** to the closed state **301.**

While Figure 4a is an illustration of the concept, and not to scale for the said purpose, it is generally clear that the readout phase **602** is much longer than the integration phase **600.** The transitions **307,309** of the external shutter component **3** have comparable length, when not longer, than the integration phase **600.** Ideally the major part readout phase **602** correlates with a closed state **301** of the external shutter component **3** and only a close to insignificant part of the readout phase **602** is performed under the open state **300** of the external shutter component **3.**

Figure 4b provides an alternative embodiment of the coupling functionality **7.** In the depicted case the command **306** to transit **307** the external shutter component **3** from the closed **301** to the open state **300,** is provided well in advance, but independently of the integration start command **606.** Since the imaging sensor performs a pixel reset **603,** opening the external shutter component significantly earlier than the integration start **606** is expected to cause no adverse effect. The integration stop command **608** not only stops the integration phase **600** of the imaging sensor **10,** but also causes **708** a generation of the external shutter closing command **308** without delay. In response, the external shutter component **3** transits **309** from the open state **300** to the closed state **301.**

Figure 4c depicts an embodiment of the coupling functionality **7,** wherein the external shutter component **3** is permanently in the open state **300.** The coupling functionality **7** receives **707** the notification **304** regarding the open state **300** of the external shutter component **3,** however the global electronic shutter functionality **6** provides the command to start **606** and stop **608** the integration phase **600** of the imaging sensor **10** largely decoupled from the controller **39** of the external shutter component **3.**

The skilled person understands that Figures 4a-c are to illustrate some salient features of some possible embodiments of the coupling functionality. The coupling functionality might comprise further features, in particular accessing and processing further data. Moreover, the depicted embodiments are non-exclusive and alternative realization of the coupling functionality are within the sense of the claimed invention.

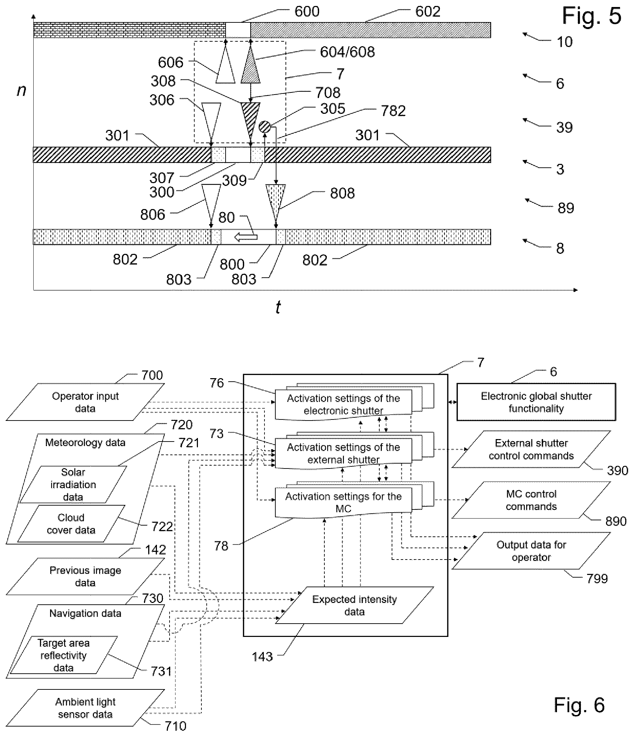

Figure 5 depicts an embodiment of the coupling functionality **7** performing a coupling of the MC **8** with the external shutter component **3** according to the first MC coupling mode. The MC **8** comprises a respective controller **89.** The MC **8** provides a compensation movement **80** in a movement-compensating phase **800,** said phase might be separated by transition phases **803** from the non-compensating phases **802** of the MC **8.** The respective start signals **306,606,806** are non-synchronized. Due to the different time scales involved it is possible that the controllers **39,89** of the external shutter component **3** and the MC **8** and perform the respective actions independently of each other and of the electronic global shutter **6.** Moreover, the imaging sensor **10** might perform a pixel reset as depicted in Figure 4a, thus any event occurred before the integration phase **600** can be, to a large degree, neglected. These embodiments and further similar embodiments are also within the sense of the present invention.

In the depicted embodiment the coupling functionality **7** provides **708** a command **308** to transit **309** to a closed state **301** of the external shutter component **3** based on a signal to stop **608** the integration phase **600** and to start **604** the readout phase **602.** The coupling functionality **7,** according to the first MC coupling mode, provides **782** a stop signal **808** for a compensation movement in response to shutter closed notification **305,** indicating a closed state **301** of the external shutter component **3.** Further MC coupling options, in particular the second and third MC coupling mode, might be provided analogously.

Figure 6 schematically depicts some possible option for the coupling functionality **7** illustrated by data flows. The data flows are represented by dashed lines. The coupling functionality **7,** by way of example, receives as input data operator input data **700,** ambient light sensor data **710,** meteorology data **720,** navigation data **730,** and previous image data **142.** The skilled person understands that further embodiments of the inventive coupling functionality **7** might receive only a part of the mentioned data as input data, or might receive further input data.

The operator input data **700** can particularly comprise preferred or forced settings, e.g. aperture size, image refresh rate, decoupling the external shutter component. The operator input data **700** might comprise manual settings, e.g. sensor resolution, time, weather realeted settings, whether daytime or nighttime photography is performed, or task related data.

The ambient light sensor data **710** might be provided by an external sensor or the camera instrument itself, in particular the ambient light sensor data **710** might be derived from processing previous image data **142.** Meteorology data **720** in the sense of the present invention especially comprise data regarding the current ambient light conditions and a forecast regarding future ambient light conditions, i.e. solar irradiation data **721** or cloud cover data **722.**

Navigation data **730** on the one hand might comprise a travel velocity of the aircraft, which is relevant for the MC control commands **890** and the activation setting **78** for the MC. Especially important is the target area reflectivity data **731,** which provide information about glossy surfaces relevant for the PLS-problem.

The coupling functionality **7** might process the ambient light sensor data **710,** and/or the meteorology data **720,** and/or the navigation data **730,** and/or the previous image data **142** to calculate an expected intensity data **143** regarding possible pixel oversaturation. The activation settings **73** of the external shutter component, the activation settings **76** of the electronic global shutter **6** and activation settings **78** for the MC could be selected on the basis of the expected intensity data **143** and the constraints between the settings **73,76,78.** Alternatively or additionally, a part of the input data might be directly processed. External shutter control commands **390,** and MC control commands **890** are provided on the basis of the respective settings **73,76,78** with respect to the state of and commands provided to the electronic global shutter functionality **6.**

The coupling functionality **7** could also provide output data **799,** in particular regarding the selected activation settings **73,76,78** for the operator.

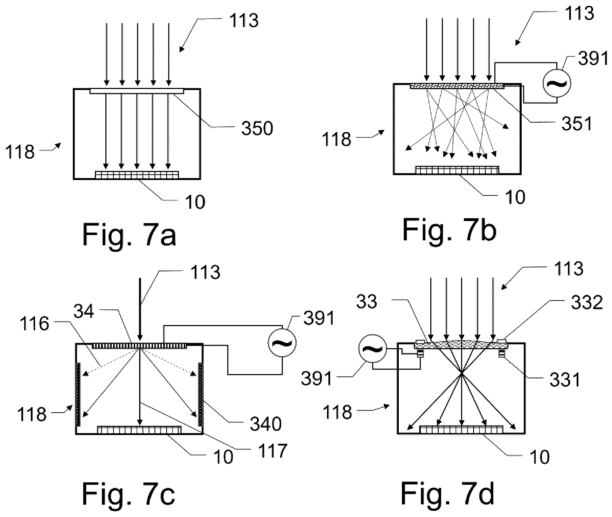

Figure 7 schematically depicts an open state **350,** and some options to reduce the light intensity by various switchable dispersive elements **33-35.** For the sake of transparency in the depicted embodiments the dispersive elements **33-35** are arranged in front of the imaging sensor **10.** While these embodiments allow the reduction of the size of the dispersive element **33-35,** which results on lower costs, power consumption and environmental impact of the manufacturing, other embodiments within the sense of the invention are also possible. Particularly the switchable dispersive elements **33-35** might be placed in front of the camera instrument (not shown) as a replaceable additional component.

Figure 7a represents an open state **350** of a switchable diffuser. Particularly in the depicted case the open state **350** corresponds to a high transmission state, wherein the incoming light **113** is transmitted towards the imaging sensor **10** with substantially no loss, particularly the intensity of the transmitted light **118** is at least 90% of the incoming light **113.** The skilled person understands that while high transmission is preferable the present invention might also be realized by dispersive elements having lower transmission rates. Particularly some state of the art liquid crystal shutters might provide less than 60% transmission in the open state. In the embodiment depicted in Figure 7a the open state **350** of the diffuser provides no imaging, i.e. the transmitted rays **118** essentially follow the beam path of the incoming rays **113.** Other embodiments the external dispersive component might have an additional imaging functionality and provide a focusing in the open state **350.**

Figure 7b shows a switchable diffuser in the closed state **351.** The switching is driven by a signal generator **391** (not shown in Figure 7a). In the clear or open state of the diffuser, the material is homogenous and thus does not scatter (as depicted in Figure 7a). In the diffuse or closed state **351,** the refractive index varies randomly so that the material becomes opaque. I.e. the transmitted light **118** is scrambled and does not represent the incoming light **113.** The diffuser **351** might absorb or reflect a portion of the incoming light **113.**

Figure 7c shows an alternative embodiment of the external dispersive component, a switchable diffraction grating **34** in the closed state. The switching is driven by a generator **391.** For the sake of transparency only one ray of the incoming light **113** is shown. The zeroth order **117,** or undeflected part, of the transmitted light **118** is transmitted with reduced intensity. The higher order portions **116** have large enough steering angle, so that they separate completely from the primary image. In the depicted embodiment the higher order portions **116** are not reaching the image sensor **10** but are deflected to a beam dump **340.** For suppressing the PLS and similar broadband artifacts the wavelength dependence of the steering angle is advantageous as the intensity of the higher order portions **116** is reduced.

Figure 7d shows another alternative embodiment of the external dispersive component, a liquid lens **33** in the closed state. The shape of the liquid lens **33** is such that incoming light **113** is defocused, i.e. a part of the transmitted light **118** does not reach the imaging sensor **10.** The skilled person understands that apart from such global defocusing the defocusing has a local effect, as shown in Figure 3c, that the image will be blurred. Owing to the blurring the strong PLS signal, or similar artifacts, is imaged to a plurality of pixels with reduced intensity. Preferably the intensity is reduced to a level that no parasitic signal above the background noise level is produced during the readout phase.

The depicted liquid lenses contain a transparent liquid shaped into the shape of a lens by a thin, flexible transparent membrane. By pumping more or less liquid into the lens cavity, the power of the lens can be varied. The depicted pump is realized by a permanent magnet **331** and an electromagnetic element **332** driven by a signal generator **391.** The pump pushes the liquid another part of the membrane, and 1 ms switching speed can be achieved.

Although the invention is illustrated above, partly with reference to some specific embodiments, it must be understood that numerous modifications and combinations of different features of the embodiments can be made. All of these modifications lie within the scope of the appended claims.

## Claims

1. An aerial camera instrument (1) configured to acquire high-resolution aerial images (141) from a target area (2), the aerial camera instrument (1) comprising
- an imaging sensor (10), wherein the imaging sensor (10)
∘ comprises an electronic global shutter functionality (6) providing for each pixel (100) a simultaneous start (606) and stop (608) for an integration phase (600) corresponding to capturing light (110) and converting (120) it into pixel-resolved electronic signals (121), and
∘ exhibits a readout phase (602) corresponding to transforming (140) the pixel-resolved electronic signals (121) into digital image data (141),
- an external dispersive component (3,31-35) being configured to provide an open state (300,310,350) and a closed state (301,311,351), wherein
∘ the open state (300,310,350) provides light transmission (118) towards the imaging sensor (10), and
∘ the closed state (301,311,351) provides reduced, in particular at least locally reduced, light transmission (118) towards the imaging sensor (10) as compared to the open state (300,310,350),
- a coupling functionality (7) configured to provide a settable coupling of the electronic shutter functionality (6) and the external dispersive component (3,31-35), wherein the settable coupling provides for different activation settings (73,76) of the electronic shutter functionality (6) and the external dispersive component (3,31-35) relative to each other.

2. The camera instrument according to claim 1, wherein the dispersive element comprises (3,31-35) a switchable diffuser (35), in particular, wherein the diffuser (35) comprises
- a first transparent solid component (358), in particular a first glass plate,
- a second transparent solid component (359), in particular a second glass plate,
- a liquid component, particularly a liquid crystal, arranged between the first (358) and second transparent solid components (359) and
- an electric actuation element (391) electrically coupled to the liquid component and configured to provide the open state (350) and the closed state (351) by respectively applying a first electric signal and a second electric signal to the liquid component, in particular wherein the first and second electric signals are provided by a square-wave signal with peak-to-peak voltage in excess of 50 V.

3. The camera instrument (1) according to any one of claims 1 to 2, wherein the external dispersive component (3,31-35) comprises an element with a polymer-dispersed liquid crystal (32).

4. The camera instrument (1) according to any one of the preceding claims, wherein the external dispersive component (3,31-35) comprises a liquid lens (33).

5. The camera instrument (1) to any one of the preceding claims, wherein the external dispersive component (3,31-35) comprises a diffraction grating,
in particular, wherein the diffraction grating is embodied as a switchable grating (34) comprising structured alignment layers formed of liquid crystal.

6. The camera instrument according to any one of the preceding claims, wherein the external dispersive component (3,31-35) is configured to provide variable scattering states, wherein
- a first scattering state, corresponding to the open state (300,310,350), provides a low loss transmission of the incoming light (113), in particular provides a transmission above 90%,
- a second scattering state, corresponding to the closed state (301,311,351), provides at least one of
∘ deflecting a part of the incoming light (113), such that the deflected part is not imaged on the imaging sensor (10),
∘ diffusing a part of the incoming light (113) such that transmitted rays of light imaged to a plurality of pixels (100) of the imaging sensor (10), each with reduced intensity,
∘ absorbing a part of the incoming light (113), and
∘ reflecting a part of the incoming light (113),
in particular wherein an imaging contrast is reduced by at least a factor of 2, particularly at least a factor of 10.

7. The camera instrument according to any one of the preceding claims, wherein
- the electronic shutter functionality (6) is configured to provide electronic shutter speed of at least 1/2000 s, and
- the electronic shutter functionality (6) is configured to provide a shutter efficiency in excess of 1000.

8. The camera instrument (1) according to any one of the preceding claims, wherein the coupling functionality (7) is configured to provide different coupling settings as a function of different ambient light conditions and/or different reflection conditions (731) associated with the target area (2),
in particular wherein
- the camera instrument (1), in particular the imaging sensor (10), provides for measuring an ambient light intensity and/or for determining an expected intensity (143) within an image (141) of the imaging sensor (10), and
- the coupling functionality (7) is configured to provide for automatic setting of the different activation settings (73,76) as a function of the measured ambient light intensity (710) and/or the expected intensity (143) within the image (141) of the imaging sensor (10).

9. The camera instrument (1) according to any one of the preceding claims, wherein the coupling functionality (7) is configured to provide for automatic setting of the different activation settings (73,76) as a function of meteorological information (720), in particular solar irradiation information (721) and/or cloud coverage information (722).

10. The camera instrument (1) according to any one of the preceding claims, wherein the different activation settings (73,76) comprise a setting wherein only the electronic shutter functionality (6) is activated and a setting wherein both the electronic shutter functionality (6) and the external dispersive component (3,31-35) are activated, in particular wherein the different activation settings (73,76) comprise a setting wherein
- the open state (300,310,350) of the external dispersive component (3,31-35) is set for the integration phase (600),
- the closed state (301,311,351) of the external dispersive component (3,31-35) is set for at least a part of the readout phase (602).

11. The camera instrument (1) according to any one of the preceding claims, wherein the different activation settings (73,76) comprise settings providing different invocation of the closed state (301,311,351) of the external dispersive component (3,31-35) relative to a time interval provided by the readout phase (602) of the imaging sensor (10).

12. The camera instrument (1) according to any one of the preceding claims further comprising a motion compensation unit (8), wherein
- the motion compensation unit (8) is configured
∘ to derive motion data corresponding to a relative motion (40) of the camera instrument (1) to the target area (2) projected onto a stabilization plane (400), and
∘ to provide start (806) and stop signal (808) for a compensation movement (80) of the camera instrument (1) based on the derived motion data,
- the coupling functionality (7) is configured to provide settable activation settings (78) for the motion compensation unit (8) regarding a coupling with any one of the electronic shutter functionality (6) and the external dispersive component (3,31-35).

13. The camera instrument (1) according to claim 12, wherein the coupling functionality (7) is configured to provide a stop signal (808) for a compensation movement (80) of the camera instrument (1),
- in a first MC coupling mode in response (782) to shutter closed notification (305), indicating a closed state (301,311,351) of the external dispersive component (3,31-35),
- in a second MC coupling mode in response to a readout start notification, indicating a readout phase (602) of the imaging sensor (10), and
- in a third MC coupling mode in response to a readout stop notification, indicating the completion of the readout.

14. The camera instrument (1) according to any one of the preceding claims, wherein the imaging sensor (10)
- is embodied as a back-illuminated CMOS imaging sensor comprising at least 4000×4000 pixels (100), and
- is configured to provide a refresh rate of at least 1 image/sec,
in particular wherein
- the imaging sensor (10) is embodied as an RGB sensor, and/or a panchromatic sensor, and/or a sensor configured to provide near-infrared images, and
- a photosensitive area of the imaging sensor (10) is smaller than an area of a full-frame imaging sensor, in particular a diagonal of the sensitive area is 19.3 mm.

15. The camera instrument (1) according to any one of the preceding claims comprising a support element configured to provide a releasable fitting between the external dispersive component (3,31-35) and a housing of the camera instrument (1),
in particular wherein the support element comprises one of
- a bayonet mount,
- a groove or rail mount,
- a threaded mount,
- a quick release unit.
